# EUROPÄISCHE PATENTSCHRIFT

(11) **EP 1 576 867 B1**
(45) Veröffentlichungstag und Bekanntmachung des Hinweises auf die Patenterteilung: **03.05.2006**
(21) Anmeldenummer: 03813552.1
(22) Anmeldetag: 31.10.2003
(51) Int. Cl.: H05K 7/14

(54) **TECHNOLOGIE-PLATINE MIT MODULARER SPS-INTEGRATION UND ERWEITERUNG**
PROCESS-ORIENTED BOARD WITH MODULAR SPC INTEGRATION AND EXPANSION
CARTE ORIENTEE PROCESSUS A INTEGRATION ET EXTENSION MODULAIRE D'AUTOMATE PROGRAMMABLE

(30) Priorität: 19.12.2002 DE 10259415
(43) Veröffentlichungstag der Anmeldung: 21.09.2005
(73) Patentinhaber: Demag Ergotech GmbH, 90571 Schwaig (DE)
(72) Erfinder: DACHS, Oswald, 90452 Eckental (DE); REINECKE, Dieter, 90556 Cadolzburg (DE); LÜTTICH, Karl-Rudolf, 06567 Bad Frankenhausen (DE); NICKL, Rainer, 90491 Nürnberg (DE)
(74) Vertreter: Wilhelm, Ludwig
(86) Internationale Anmeldenummer: PCT/EP2003/012111
(87) Internationale Veröffentlichungsnummer: WO 2004/057937

(56) Entgegenhaltungen:
- DE-A- 19 615 093
- US-A- 5 984 734
- US-B1- 6 452 785

## Beschreibung

Die vorliegende Erfindung betrifft eine Steuerungsvorrichtung für eine Maschine, wie sie insbesondere zum Steuern einer Spritzgießmaschine Anwendung findet.

Die Steuerungsvorrichtung einer Spritzgießmaschine ist gewöhnlicherweise modular aufgebaut, wobei verschiedene Module verschiedene Ansteueraufgaben übernehmen sowie die Verbindung mit bestimmten steuerbaren Einrichtungen der Spritzgießmaschine, wie z. B. Drucksensor und motorischem Antrieb herstellen. Diese Module sind über einen Rückwandbus miteinander verbunden und zumeist in ein sogenanntes "Rack" einsteckbar ausgeführt, auf dessen Rückseite eine sogenannte Bus-Platine mit einem Rückwandbus angebracht ist. Die Verbindung zwischen Modulen und Rückwandbus erfolgt meist über Steckkontakte. Ein Modul stellt bisher eine SPS (Speicherprogrammierbare Steuerung) zur Verfügung, in der eine Sicherheitslogik der Spritzgießmaschine hinterlegt ist. Daneben umfasst die Steuerungsvorrichtung eine sogenannte Verdrahtungsplatine, über die die Verdrahtung inklusive der Sicherheitsverschaltung der Maschine ausgeführt ist und die eine Spannungsverteilung für die Steuerungsvorrichtung bereitstellt. Die Verdrahtungsplatine stellt demgemäss die Spannungsverteilung mit Absicherungen, die Sicherheitsverschaltung inklusive eventueller Sicherheitsrelais sowie weitere Baugruppen zur Verfügung sowie einen möglichst großen Anteil der Verdrahtung der Maschine und ihre Sicherheitsverschaltung. Ein sogenanntes Technologiemodul, das fest auf der Verdrahtungsplatine angebracht ist, enthält einen Basisumfang für analoge und digitale Steuerungsein-/ausgangsverbindungen zu der Spritzgießmaschine. Die Verbindung zwischen den Steuerungsmodulen bzw. der Bus-Platine und auf der Verdrahtungsplatine vorgesehenen Baugruppen erfolgt separat über einzelne Kabel.

Bis jetzt war die Montage einer solchen Steuerung wegen der vielen separaten Bauteile sehr aufwendig und dadurch auch fehleranfällig. Insbesondere die separate Verdrahtung der einzelnen Einheiten der Verdrahtungsplatine mit den Steuerungsmodulen war unübersichtlich und stellte einen Risikofaktor dar. Bei einem Aufrüsten der Spritzgießmaschine und damit einer Zunahme der anzusteuernden Komponenten ergab sich das Problem einer adäquaten Ansteuerung durch die bestehende Steuerung. Ein weiterer Nachteil ergab sich daraus, dass jede Spritzgießmaschinen-Baureihe individuell verdrahtet werden musste.

Aufgabe der vorliegenden Erfindung ist es, eine Steuerungsvorrichtung für eine Maschine zu schaffen, die durch Standardisierung eine Kostenreduzierung ermöglicht, zudem eine geringe Fehlerwahrscheinlichkeit aufweist, und dabei flexibel einsetzbar und möglichst kompakt gestaltet ist.

Diese Aufgabe wird durch eine Steuerungsvorrichtung entsprechend den Merkmalen des Anspruchs 1 gelöst.

Entsprechend der vorliegenden Erfindung umfasst eine Steuerung für eine Maschine, wie sie insbesondere bei Spritzgießmaschinen zum Einsatz kommt, eine Bus-Platine, die Kommunikationsverbindungen zwischen verschiedenen Einheiten, bevorzugt gemäß einer lokalen Synchronbus- oder Feldbus-Architektur bereitstellt, eine Verdrahtungsplatine und ein separates Technologie-Modul. Dieses weist jeweils eine oder mehrere Technologie-Platinen auf, die einen Basisumfang für eine SPS (speicherprogrammierbare Steuerung) zur Verfügung stellen. Das Technologie-Modul ist nicht wie früher integral mit der Verdrahtungsplatine sondern als separates Bauteil ausgeführt, und weist Stecker zweiter bzw. dritter Art auf, über die es direkt mit der Bus-Platine bzw. der Verdrahtungsplatine verbindbar ist, und stellt so eine Brückung, d.h. eine Verbindung, zwischen diesen beiden Platinen her, wodurch sich die Verdrahtung zwischen diesen reduzieren lässt. Mindestens ein Steuerungsmodul, das Steuerungsaufgaben an der Maschine übernimmt, ist an die Bus-Platine über Steckkontakte erster Art einsteckbar gefertigt. Weitere Steuerungsmodule können nach Bedarf hinzugefügt werden. Die Steuerungsvorrichtung lässt sich also durch Hinzufügen von zusätzlichen Steuerungsmodulen leicht an unterschiedliche Maschinenanforderungen anpassen. Durch Verwendung von vorkonfektionierten Steckkontakten zum Verbinden der einzelnen Elemente der Steuerung untereinander ergibt sich eine Flexibilisierung im Entwurf der Steuerungsvorrichtung und der Verdrahtungsaufwand wird verringert. Dadurch lässt sich die Steuerung kompakt gestalten, und es kann Platz eingespart werden. Die Verwendung von vorkonfektionierten Bauteilen sorgt für eine zusätzliche Kostenreduzierung.

Das Technologiemodul stellt unter anderem verschiedene digitale und/oder analoge Ein- und Ausgänge zur Verfügung, über die die Verbindung mit der Maschine hergestellt werden kann. Zusätzlich können spezielle Schnittstellen wie beispielsweise für ein EEPROM vorgesehen werden. Die Kontaktierung erfolgt bevorzugt über vorkonfektionierte Stecker.

In einer besonders bevorzugten Ausführungsform ist als ein Steuerungsmodul ein CPU-Modul vorgesehen, das die Aufgaben einer SPS ausführt. Auch eine BusAnschaltung kann als ein Steuerungsmodul vorgesehen werden, die als Schnittstelle zu einer externen CPU dient, die dann die SPS-Aufgaben übernimmt oder den Leistungsumfang der SPS erweitert. Es ist allerdings auch möglich, direkt im Technologiemodul eine CPU für die Aufgaben der SPS vorzusehen, wodurch sich Steckplatz sparen lässt.

Die Verdrahtungsplatine umfasst im wesentlichen die Sicherheitsverschaltung der Maschine. So können beispielsweise Positionsschalter direkt angeschlossen werden, die nach der europäischen Norm EN 201 zur Überwachung von Schutztüren einer Spritzgießmaschine verwendet werden. Das für die Überwachung verwendete Programm, die sogenannte Sicherheitslogik, kann in einem nichtflüchtigen Speicher hinterlegt werden, wofür man ein sogenanntes EN 201 Modul einsetzt. Dieses Modul wird bevorzugt auf der Verdrahtungsplatine vorgesehenen, kann aber auch im Technologiemodul angesiedelt sein. Bevorzugt umfasst es neben dem nichtflüchtigen Speicher einen eigenen Controller, der die Sicherheitslogik abarbeitet und beispielsweise über einen 8 Bit-Bus mit der SPS der Maschine verbunden ist. Über eigene Ausgänge bedient das Modul die Sicherheitsverschaltung der zu steuernden Maschine und gewährleistet somit die Einhaltung der Sicherheitsvorschriften durch die von der erfindungsgemäßen Steuerungsvorrichtung gesteuerte Maschine. So können beispielsweise verschiedene Spannungsversorgungen zu Digitalausgängen für die Maschine im nichtsicheren Zustand hardwaremäßig über auf der Verdrahtungsplatine integrierte Sicherheitsrelais abgeschaltet werden.

Des weiteren stellt die Verdrahtungsplatine eine Standardverdrahtung zu der zu steuernden Maschine, die bevorzugt über Steckverbinder erfolgt, und die Spannungsverteilung für die gesamte Steuerungsvorrichtung zur Verfügung. Die Platine ist bevorzugt so ausgelegt, dass die vorgesehene Sicherheitsverschaltung entsprechend den Baureihen bzw. gewählten Optionen erweiterbar ist. Die einzelnen auf der Verdrahtungsplatine vorgesehenen Bauteile werden soweit möglich durch vorkonfektionierte Kabelsätze über Stecker kontaktiert. Vorteilhafterweise können direkt an den Steckkontakten die Signale gemessen werden. Hierbei werden Größen, die häufig gemessen werden, bevorzugt auf einen 37 poligen D-Sub-Stecker zusammengefasst. Zu den auf der Verdrahtungsplatine vorgesehenen Bauteilen zählen beispielsweise Hardware-Relais, Sicherheits-Relais, EEPROM's für den Maschinenspeicher und unterschiedliche Messpunkte.

Jedoch kann auch das Technologiemodul einen nichtflüchtigen Speicher mit einer Sicherheitslogik sowie einen Controller umfassen, auf dem die Sicherheitslogik läuft, die im wesentlichen die auf der Verdrahtungsplatine angeordnete Sicherheitsverschaltung der zu steuernden Maschine bedient und somit die Einhaltung der Sicherheitsvorschriften durch die von der erfindungsgemäßen Steuerung gesteuerte Maschine gewährleistet.

Gemäß der vorliegenden Erfindung ist das Technologiemodul durch ein oder mehrere Erweiterungsmodule beliebig erweiterbar, um auch für Maschinen höherer Komplexität einsetzbar zu sein. Dieses Erweiterungsmodul stellt zusätzliche Eingangs- bzw. Ausgangs-Baugruppen bereit und verfügt über eine Eingangsschutzschaltung und Ausgangstreiber, die Ansteuerung wird von dem Technologiemodul übernommen.

Um die Steuerung besonders kompakt zu gestalten, können die Bus-Platine und die Verdrahtungsplatine vorteilhaft auf getrennten Bereichen einer einzigen Platine integral ausgebildet sein.

Für die Halterung der erfindungsgemäßen Steuerung ist bevorzugt ein Modulträger vorgesehen, an dem die Bus-Platine, die Verdrahtungsplatine und das Technologiemodul sowie eventuelle Erweiterungsmodule befestigbar sind. Hierbei ist es besonders vorteilhaft, wenn die Platine bzw. die Platinen des Technologiemoduls so am Modulträger gehaltert sind, dass sie senkrecht zu der integral ausgeführten Platine bzw. zu den Platinen des Busses und der Verdrahtung angeordnet ist bzw. sind. Diese letzteren Platinen werden im wesentlichen planparallel zum Halter gelagert werden.

Die Bus-Platine und die Verdrahtungsplatine werden bevorzugt auf einer hinteren Seite des Modulträgers befestigt, während das Technologiemodul auf einer Vorderseite des Modulträgers angebracht ist, da so die auf diesem vorgesehen Ein-/Ausgangsverbindungen zu der anzusteuernden Maschine leichter zugänglich sind. Der Modulträger weist bevorzugt Ausnehmungen auf, durch die die Steckkontakte zwischen verschiedenen Modulen bzw. Platinen, d. h. zwischen den Steuerungsmodulen und der Bus-Platine sowie zwischen der Bus-Platine bzw. Verdrahtungsplatine und dem Technologiemodul führbar sind. Ausnehmungen über der Verdrahtungsplatine erlauben das direkte Durchführen der Verbindungen der Sicherheitsverschaltung. Zusätzlich sollte der Modulträger nach Art eines "Racks" weitere Ausnehmungen aufweisen, in die die Steuerungsmodule einrastbar ausgeführt sind. Die Module können dann ohne großen Aufwand durch einfaches Einrasten bevorzugt an der Vorderseite des Modulträgers befestigt werden, wobei gleichzeitig über Stecker und Steckkontakte erster Art, die durch die zuerst genannten Ausnehmungen greifen, eine Verbindung zwischen den Steuerungsmodulen und der Bus-Platine hergestellt wird.

Bevorzugt sind auf dem Modulträger einer erfindungsgemäßen Steuerung bereits Sockel für eventuelle Erweiterungsmodule des Technologiemoduls vorgesehen. Hierdurch kann der Umfang an Ein-/Ausgangsverbindungen zwischen Spritzgießmaschine und Steuerung erweitert werden. Um die erfindungsgemäße Steuerung noch kompakter und flexibler im Einsatz zu gestalten, können die Ein-/Ausgangsverbindungen des Technologiemoduls bzw. seiner Erweiterungsmodule durch vorkonfektionierte Frontstecker hergestellt werden.

Die Steckverbindungen erster Art, die die Verbindung der Steuerungsmodule mit der Bus-Platine herstellen, sind bevorzugt vorkonfektioniert und so ausgebildet, dass sie sowohl für digitale als auch für analoge Baugruppen einsetzbar sind.

Bei Verwendung von mehreren Technologie-Platinen im Technologiemodul wird die Verbindung zwischen den Technologie-Platinen vorzugsweise über eine Querverbindung hergestellt, und nur eine der Platinen verfügt über einen Stecker zweiter bzw. dritter Art, der sie und die weiteren Platinen mit der Bus-Platine bzw. der Verdrahtungsplatine verbindet. Ähnlich sieht es bei der Verwendung von Erweiterungsmodulen aus, die ebenfalls nicht direkt mit den Platinen verbunden sind, sondern beispielsweise mittels einer Querverbindung über das Technologiemodul Kontakt zur diesen haben.

Für die Ansteuerung der einzelnen Elemente der Steuerung wird bevorzugt ein Hochgeschwindigkeits-Feldbussystem eingesetzt, das eine Multi-point-Verbindung auf der Bus-Platine bereitstellt.

Durch die vorliegende Erfindung ist es gelungen, die Schnittstelle zwischen Steuerung und Leistung der Verdrahtungsplatine durch Einsatz einer separaten Technologieplatine zu standardisieren. Das Technologie-Modul stellt die Brückung, d.h. die Verbindung, zwischen Verdrahtungsplatine und Bus-Platine her. Um die Flexibilität der Steuerungsvorrichtung im Einsatz weiter zu erhöhen, können auf der Verdrahtungsplatine weitere Sockel für Zusatzeinheiten wie Relais vorgesehen sein, während auf der Bus-Platine beliebige Steuerungsmodule einsteckbar sind. Außerdem können diverse Wegmesssysteme, z. B. unter Einsatz von P-Schnittstellen und Potentiometern eingesetzt werden. Auch ist es möglich die Zylindererkennung auf aktuelle Bedürfnisse auszulegen und hierfür mehrere Eingänge oder vorkonfektionierte Steckverbindungen zur Datenübertragung zu benutzen. Hierdurch kann die Schnittstelle zum Zylinder der Spritzgießmaschine vereinheitlicht werden. Durch die Modularität und Flexibilität ist die Steuerungsvorrichtung gemäß der vorliegenden Erfindung für diverse Baureihen einsetzbar und leicht anpassbar.

Beispielhaft soll eine Ausführungsform einer erfindungsgemäßen Steuerung anhand der folgenden Zeichnungen beschrieben werden. Es zeigen:
- Fig. 1: eine schematische Draufsicht auf eine Ausführungsform der erfindungsgemäßen Steuerung und
- Fig. 2: eine schematische Funktionsaufgliederung der Steuerung gemäß Fig. 1.

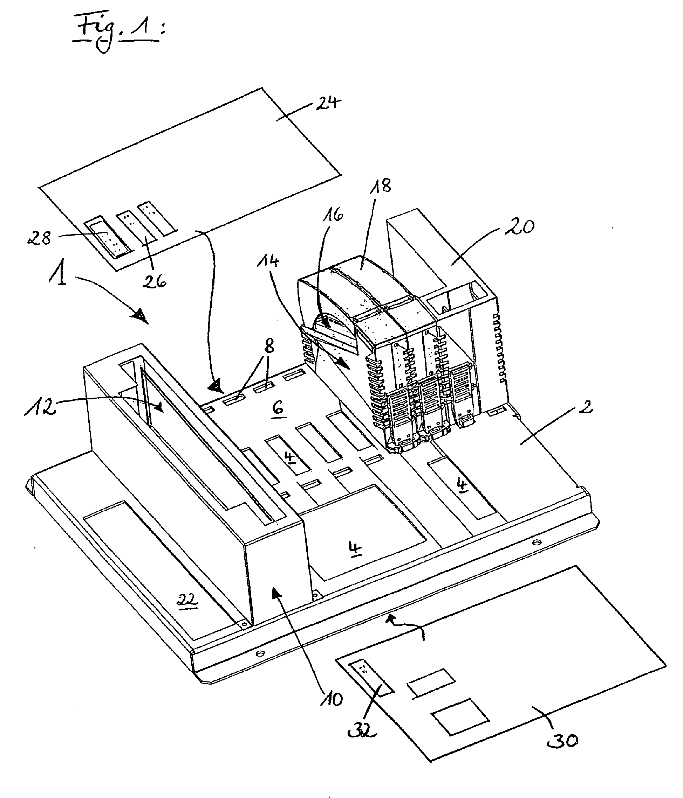

Die in Fig. 1 dargestellte Steuerungsvorrichtung 1, insbesondere zum Steuern einer Spritzgießmaschine, umfasst einen Modulträger 2, der aus gestanztem und geformtem Blech mit unterschiedlichen Ausnehmungen 4, 8, 22 besteht. Auf diesem Modulträger 2 sind die verschiedenen Elemente der Steuerung gehaltert. In Fig. 1 ist auf der linken Seite ein Technologiemodulgehäuse 10 schematisch dargestellt. In diesem befindet sich eine Technologie-Platine 12. Durch die offene Oberseite des Technologiemoduls können Anschlüsse von der Technologie-Platine 12 weggeführt werden. Bevorzugt wird man für die Kontaktierung hauptsächlich vorkonfektionierte Steckkontakte bzw. Stecker in der Art von Frontsteckem vorsehen, die durch die offene Oberseite geführt werden. Links neben dem Technologiemodulgehäuse 10 befindet sich ein Sockel 22 für ein optionales Erweiterungsmodul.

Der in Fig. 1 hinten rechts gelegene Bereich des Modulträgers 2 ist als sogenanntes Rack 6 ausgebildet, auf dem Steckmodule 14, bei denen es sich um Steuerungsmodule handelt, über einen Einrastmechanismus befestigt werden können. Hierfür sind im Bereich des Racks 6 Rastverbindungsausnehmungen 8 vorgesehen. Ebenfalls sind in diesem Bereich Ausnehmungen 4 vorgesehen, durch die die Stecker erster Art der Steuerungsmodule 14 geführt werden können. Im vorliegenden Fall sind die Steuerungsmodule 14 als Kompaktsteuerungselemente ausgeführt, die eine zweite Kontaktierungsmöglichkeit über einen Steckkontakt 16 bereitstellen, der durch eine Abdeckhaube 18 geschützt wird. An ihnen können LED's zur Betriebsanzeige sowie andere Funktionselemente vorgesehen sein. Im Bereich des Racks 6 ist außerdem ein CPU-Modul 20, das in der Fig. 1 zwei Steckplätze beansprucht, oder alternativ eine Busanschaltung vorgesehen, die eine Verbindung zu einer externen CPU herstellt, die die Funktionen eines Steuerungsmoduls bzw. einer SPS übemimmt. Die Verbindung zwischen dem CPU-Modul 20 bzw. der Busansteuerung und den anderen Steuerungsmodulen 14 erfolgt über eine auf der Rückseite des Modulträgers 2 im Bereich des Racks 6 angeordnete Bus-Platine 24. Auf dieser Bus-Platine 24 sind Steckkontakte erster Art 26 vorgesehen, in die die Steuerungsmodule 14 bzw. das CPU-Modul 20 durch die Ausnehmungen 4 eingesteckt werden können. Die Bus-Platine 24 verfügt auch über mindestens einen Steckkontakt zweiter Art 28, über den eine Verbindung zu dem Technologiemodul bzw. der Technologie-Platine 12 hergestellt werden kann.

Im gemäß der Fig. 1 vorderen rechten Bereich des Modulträgers 2 der erfindungsgemäßen Steuerung 1 ist rückseitig eine Verdrahtungsplatine 30 angebracht, auf der im wesentlichen eine Sicherheitsverschaltung sowie die Verdrahtung der zu steuernden Maschine sowie eine Spannungsverteilung für die Steuerung vorgesehen sind. Auf dieser angeordnete, in der Fig. 1 nur schematisch dargestellte Bauteile sowie Verdrahtungsverbindungen können durch die Ausnehmungen 4 im Modulträger 2 geführt werden. Ferner verfügt die Verdrahtungsplatine 30 über einen Steckkontakt dritter Art 32, über den sie mit der bzw. den Technologie-Platinen 12 und über diese mit der Bus-Platine verbunden werden kann. Nicht dargestellt ist die auf ihr vorgesehene Spannungsverteilung für die ganze Steuerung.

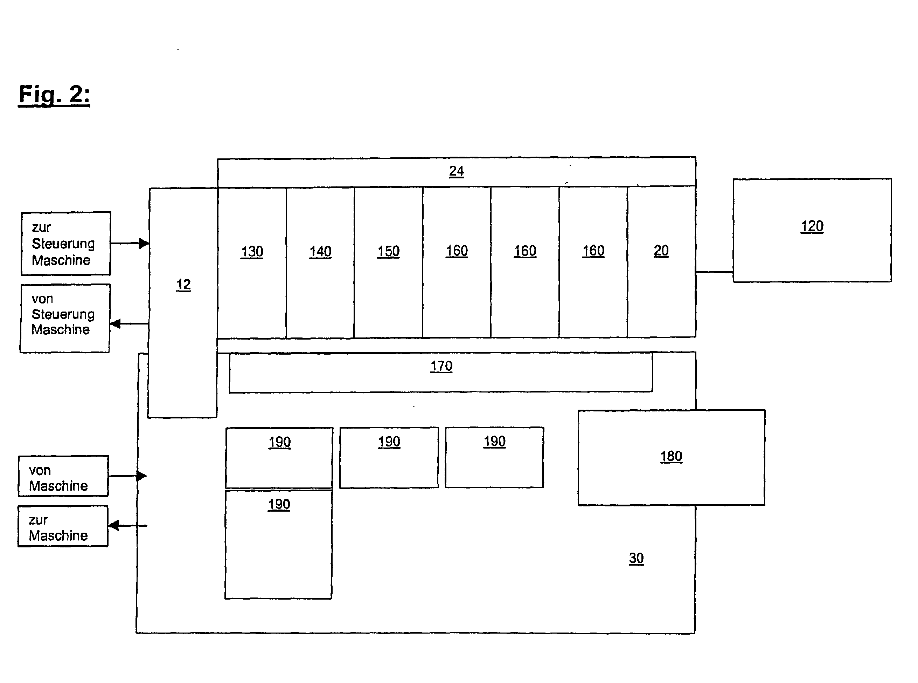

Fig. 2 zeigt den konzeptionellen Aufbau der erfindungsgemäßen Steuerung 1, die wesentlichen Informationsflüsse sind schematisch mit Pfeilen in den Kästen links in der Figur dargestellt. Im oberen Bereich sind einige Steuerungsmodule 14 mit möglichen Belegungen angegeben. So können z. B. ein sog. Temperatur- 150, ein A-nalogmischmodul 140 , eine P-Schnittstelle 130 für Wegmesssysteme oder ähnliches vorgesehen sein. An den nicht belegten Steckplätzen 160 können nach Bedarf weitere Steuerungsmodule verbunden werden. Über die oben rechts gezeigte CPU 20 oder Busanschaltung können weitere Steuerungsmodule eingebunden werden, wie beispielsweise seltene Zusatzeinheiten 120, maschinentypabhängige Funktionen oder sonstige Sonderoptionen.

Auf der in Fig. 2 unten dargestellten Verdrahtungsplatine 30 befindet sich die Spannungsverteilung und Absicherung 170 bzw. 180 sowohl für die gesamte Steuerungsvorrichtung 1 als auch für die Steuerungsmodule. Hier sind das die Sicherheitslogik umfassende EN 201 Modul, die Sicherheitsverschaltung gemäß EN 201 für die Überwachung von Schutztüren angeordnet, die die Sicherheit der Maschine im Betrieb gewährleistet, sowie unterschiedliche Baugruppen 190, beispielsweise Hardware-Relais, Messpunkte, Sicherheitsrelais und Elemente für die feste Verdrahtung wie Brücken, Löschglieder und ähnliches. Die Verbindungen zur Maschine erfolgen meist über vorkonfektionierte Kabelsätze, was die Fehleranfälligkeit bei der Verdrahtung reduziert, die Übersichtlichkeit erhöht und den benötigten Platz minimiert.

Das in Fig. 2 links zwischen dem Steuerungsmodulbereich und der Verdrahtungsplatine 30 angeordnete Technologiemodul 10, 12 umfasst einen SPS-Basisumfang und stellt im wesentlichen die Eingangs- und Ausgangsverbindungen von der Steuerung zu der Spritzgießmaschine bereit. Das Technologiemodul kann eine oder mehrere Technologie-Platinen 12 umfassen, wobei diese im Fall von mehr als einer Platine untereinander über Querkontakte verbunden werden, die bevorzugt zum Stecken ausgeführt sind. Eine Aufgabe des Technologiemoduls ist die Brückung, d.h. die Verbindung, der Verdrahtungsplatine 30 mit der Bus-Platine 24. Das Technologiemodul sollte in der dargestellten Ausführungsform zumindest folgende Elemente umfassen: 32 digitale Eingänge, 24 digitale Ausgänge mit 2 A-Beaufschlagung, 8 digitale Ausgänge mit 0,7 A-Beaufschlagung, 7 analoge Temperatureingänge, 1 KTY-Eingang für Öltemperatur, 4 analoge Ausgänge von +/-10 V, 3 analoge Differenz-Eingänge von 0-10 V, 8 digitale Eingänge, die der Sicherheitsnorm EN 201 entsprechen, sowie 4 Transsonareingänge. Zusätzlich kann eine Interface-Karte für Ultraschall-Wegmesssysteme mit P-Schnittstelle vorgesehen sein.

Durch die Modularität der erfindungsgemäßen Steuerung 1, d. h. insbesondere durch die Möglichkeit, beliebige Steuerungsmodule 14 auf dem Rack hinzuzufügen, wobei jedoch ein vorgegebener Platzbedarf für die Gesamtsteuerung nicht überschritten wird, die durch Einsatz des erfindungsgemäßen Technologie-Moduls 12 standardisierte Brückung von Bus- 24 und Verdrahtungs-Platine 30 und die Erweiterbarkeit des Technologiemoduls 12, lässt sich die Steuerungsvorrichtung 1 für beliebige Maschinen-Baureihen sehr flexibel einsetzen. Dies wird zusätzlich dadurch gefördert, dass die Steckkontakte erster Art 26, die für den Anschluss der Steuerungsmodule 14 an die Bus-Platine 24 vorgesehen sind, sowohl für digitale als auch für analoge Baugruppen verwendbar sind.

Um bei höher funktionalen Maschinen eine kostenoptimale Erweiterung der Steuerungsvorrichtung durchführen zu können, kann an das Technologiemodul eine Erweiterungsbaugruppe angefügt werden, die beispielsweise über 8 analoge Ausgänge von 0-10V, 8 analoge Eingänge von 0-10V sowie 8 digitale Eingänge und 8 digitale Ausgänge von 2A verfügt. Diese Baugruppe besteht im wesentlichen nur noch aus Steckkontakten für die Ein- und Ausgänge, einer Eingangsschutzschaltung sowie Ausgangstreibern, die Ansteuerung wird vom eigentlichen Technologiemodul übemommen.

Die Vorteile der vorliegenden Erfindung sind also in der Vereinheitlichung bei gleichzeitiger Erhöhung der Flexibilität einer modularen Steuerungsvorrichtung zu sehen, was zu Kostenreduzierung und Platzersparnis im Schaltschrank führt, und zudem den Vorteil hat, dass die Steuerung universell einsetzbar und dennoch an die jeweilige Bedürfnisse anpassbar ist.

### Bezugszeichenliste:

- 1: Steuerung
- 2: Modulträger
- 4: Ausnehmungen
- 6: Rack
- 8: Rastverbindungsausnehmungen
- 10: Technologiemodulgehäuse
- 12: Technologie-Platine
- 14: Steuerungsmodul
- 16: Steckkontakt
- 18: Abdeckhaube
- 20: CPU-Modul
- 22: Sockel für Erweiterungsmodul
- 24: Bus-Platine
- 26: Steckkontakt erster Art
- 28: Steckkontakt zweiter Art
- 30: Verdrahtungsplatine
- 32: Steckkontakt dritter Art
- 120: Zusatzeinheiten
- 130: P-Schnittstelle
- 140: Analog Mischmodul
- 150: Temperaturmodul
- 160: Reservesteckplatz
- 170: Spannungsverteilung Steuerung
- 180: Spannungsverteilung Maschine
- 190: Baugruppen

## Patentansprüche

1. Steuerungsvorrichtung (1) zum Steuern einer Maschine, insbesondere einer Spritzgießmaschine, umfassend:
- eine Bus-Platine (24), die über ein Bussystem eine Multi-Punkt-Verbindung bereitstellt und die über mindestens einen Steckkontakt (26) erster Art verfügt, in den jeweils ein Steuerungsmodul (14) einsteckbar ist, sowie über mindestens einen Steckkontakt zweiter Art (28), in den eine Technologie-Platine (12) einsteckbar ist,
- mindestens ein Steuerungsmodul (14) mit einem zum Steckkontakt erster Art komplementären Stecker erster Art zum Übernehmen von Steuerungsaufgaben an der Maschine,
- eine Verdrahtungsplatine (30), die über einen Steckkontakt dritter Art (32) mit der oder den Technologie-Platinen (12) verbindbar ist, und
- mindestens ein Technologiemodul, das jeweils eine oder mehrere Technologie-Platinen (12) aufweist, von denen zumindest eine über einen zum Steckkontakt zweiter Art (28) komplementären Stecker zweiter Art mit der Bus-Platine (24) und über einen zum Steckkontakt dritter Art (32) komplementären Stecker dritter Art mit der Verdrahtungsplatine (30) verbindbar ist und die einen Basisumfang an Ein-/Ausgangs-Verbindungen zur zu steuernden Maschine umfasst bzw. umfassen und eine Verbindung zwischen Bus-Platine (24) und Verdrahtungsplatine (30) herstellt.

2. Steuerungsvorrichtung nach Anspruch 1,
bei der als ein Steuerungsmodul ein CPU-Modul (20) vorgesehen ist.

3. Steuerungsvorrichtung nach Anspruch 1 oder 2,
bei der als ein Steuerungsmodul eine Busanschaltung zu einer externen CPU vorgesehen ist.

4. Steuerungsvorrichtung nach einem der Ansprüche 1 bis 3,
bei der die Verdrahtungsplatine (30) im wesentlichen eine Sicherheitsverschaltung, eine Verdrahtung der zu steuernden Maschine sowie eine Spannungsverteilung umfasst.

5. Steuerungsvorrichtung nach Anspruch 4,
bei die Verdrahtungsplatine (30) einen nichtflüchtigen Speicher mit einer Sicherheitslogik und einem Controller umfasst, der die Sicherheitsverschaltung bedient.

6. Steuerungsvorrichtung nach Anspruch 4,
bei der das Technologiemodul einen nichtflüchtigen Speicher mit einer Sicherheitslogik und einem Controller umfasst, der die auf der Verdrahtungsplatine (30) angeordnete Sicherheitsverschaltung bedient.

7. Steuerungsvorrichtung nach einem der Ansprüche 1 bis 6,
bei der das Technologiemodul eine CPU zum Ausführen der Aufgaben der SPS aufweist.

8. Steuerungsvorrichtung nach einem der Ansprüche 1 bis 7,
bei der das Technologiemodul ein Erweiterungsmodul umfasst, das zusätzliche Ein- bzw. Ausgabe-Baugruppen, Ausgangstreiber und/oder Eingangsschutzbeschaltung aufweist.

9. Steuerungsvorrichtung nach einem der Ansprüche 1 bis 8,
bei der die Verdrahtungsplatine (30) und die Bus-Platine (24) auf getrennten Bereichen einer einzigen Platine integral ausgebildet sind.

10. Steuerungsvorrichtung nach einem der Ansprüche 1 bis 9,
bei der ein Modulträger (2) vorgesehen ist, an dem das Technologiemodul, die Verdrahtungsplatine (30) und die Bus-Platine (24) befestigbar sind.

11. Steuerungsvorrichtung nach Anspruch 10,
bei der die Platine bzw. die Platinen (12) des Technologiemoduls am Modulträger (2) senkrecht zu der Verdrahtungsplatine (30) und der Bus-Platine (24) angeordnet ist bzw. sind.

12. Steuerungsvorrichtung nach einem der Ansprüche 10 oder 11,
bei der die Verdrahtungsplatine (30) und die Bus-Platine (24) auf einer hinteren Seite des Modulträgers (2) befestigt sind und das Technologiemodul auf einer Vorderseite des Modulträgers (2).

13. Steuerungsvorrichtung nach einem der Ansprüche 10 bis 12,
bei der der Modulträger (2) Ausnehmungen (4) aufweist, durch die die Steckkontakte zwischen den verschiedenen Modulen (16) bzw. Platinen (12, 24, 30) sowie einzelne auf der Verdrahtungsplatine (30) angeordnete Bauteile führbar sind.

14. Steuerungsvorrichtung nach einem der Ansprüche 10 bis 13,
bei der der Modulträger (2) zusätzlich Rastverbindungsausnehmungen (8) aufweist, in die die Steuerungsmodule (14) einrasten.

15. Steuerungsvorrichtung nach einem der Ansprüche 10 bis 14,
bei der auf dem Modulträger (2) Sockel (22) für ein oder mehrere Erweiterungsmodule des Technologiemoduls vorgesehen sind.

16. Steuerungsvorrichtung nach einem der Ansprüche 1 bis 15,
bei der die Ein-/Ausgangsverbindungen des Technologiemoduls bzw. seiner Erweiterungsmodule durch vorkonfektionierte Frontstecker hergestellt werden.

17. Steuerungsvorrichtung nach einem der Ansprüche 1 bis 16,
bei der die Steckkontakte erster Art (26) vorkonfektioniert und so ausgebildet sind, dass sie sowohl für digitale als auch für analoge Baugruppen eine Steckverbindung herstellen.

18. Steuerungsvorrichtung nach einem der Ansprüche 10 bis 17,
bei der die Platinen (12) des Technologiemoduls durch eine Querverbindung gekoppelt sind.

19. Steuerungsvorrichtung nach einem der Ansprüche 10 bis 18,
bei der der Modulträger (2) aus Blech besteht.

## Claims

1. A control device (1) for controlling a machine, especially an injection moulding machine, comprising:
- a bus board (24) which provides a multi-point connection via a bus system and which has at least one plug-in contact (26) of a first type, into which respectively one control module (14) can be plugged and at least one plug-in contact of a second type (28) into which a process-oriented board (12) can be plugged,
- at least one control module (14) comprising a plug of the first type complementary to the plug-in contact of the first type for taking over control functions at the machine,
- a wiring board (30) which can be connected by means of a plug-in contact of a third type (32) to the process-oriented board or boards (12) and
- at least one process-oriented module which comprises respectively one or a plurality of process-oriented boards (12) of which at least one can be connected to the bus board (24) by means of a plug of the second type complementary to the plug-in contact of the second type (28) and to the wiring board (30) by means of a plug of the third type complementary to the plug-in contact of the third type (32), which comprises or comprise a base circumference of input/output connections to the machine to be controlled and makes a connection between bus board (24) and wiring board (30).

2. The control device according to claim 1,
wherein a CPU module (20) is provided as a control module.

3. The control device according to claim 1 or claim 2,
wherein a bus connection to an external CPU is provided as a control module.

4. The control device according to any one of claims 1 to 3, wherein the wiring board (30) substantially comprises a safety interconnection, wiring of the machine to be controlled and a voltage distribution.

5. The control device according to claim 4,
wherein the wiring board (30) comprises a non-volatile memory with safety logic and a controller which operates the safety interconnection.

6. The control device according to claim 4,
wherein the process-oriented board comprises a non-volatile memory with safety logic and a controller which operates the safety interconnection arranged on the wiring board (30).

7. The control device according to any one of claims 1 to 6, wherein the process-oriented board has a CPU for executing the tasks of the SPC.

8. The control device according to any one of claims 1 to 7, wherein the process-oriented board comprises an extension module which has additional input or output assemblies, output drivers and/or input protection circuitry.

9. The control device according to any one of claims 1 to 8, wherein the wiring board (30) and the bus board (24) are integrally constructed on separate areas of a single board.

10. The control device according to any one of claims 1 to 9, wherein a module carrier (2) is provided on which the process-oriented board, the wiring board (30) and the bus board (24) are fixed.

11. The control device according to claim 10, wherein the board or the boards (12) of the process-oriented module is or are arranged on the module carrier (2) perpendicular to the wiring board (30) and the bus board (24).

12. The control device according to any one of claims 10 or 11, wherein the wiring board (30) and the bus board (24) are fixed on a rear side of the module carrier (2) and the process-oriented module is fixed on a front side of the module carrier (2).

13. The control device according to any one of claims 10 to 12, wherein the module carrier (2) has recesses (4) through which the plug-in contacts are guided between the various modules (16) or boards (12, 24, 30) as well as single components arranged on the wiring board (30).

14. The control device according to any one of claims 10 to 13, wherein the module carrier (2) additionally has locking connection recesses (8) into which the control modules (14) engage.

15. The control device according to any one of claims 10 to 14, wherein sockets (22) for one or more extension modules of the process-oriented module are provided on the module carrier (2).

16. The control device according to any one of claims 1 to 15, wherein the input/output connections of the process-oriented module or its extension modules are made by pre-assembled front plugs.

17. The control device according to any one of claims 1 to 16, wherein the plug-in contacts of the first type (26) are pre-assembled and are constructed such that they make a plug connection for digital and also for analog assemblies.

18. The control device according to any one of claims 10 to 17, wherein the boards (12) of the process-oriented module are coupled by a cross-connection.

19. The control device according to any one of claims 10 to 18, wherein the module carrier (2) consists of sheet metal.

## Revendications

1. Dispositif de commande (1) pour le contrôle d'une machine, notamment d'une machine de moulage par injection, comprenant :
- une carte de bus (24) qui établit par un système de bus une connexion multipoints et qui dispose d'au moins un contact de branchement (26) de premier type dans lequel on peut brancher respectivement un module de commande (14) ainsi que d'au moins un contact de branchement de deuxième type (28) dans lequel on peut brancher une carte de technologie (12),
- au moins un module de commande (14) comportant une prise de premier type complémentaire au contact de branchement de premier type pour prendre en charge des tâches de commande sur la machine,
- une carte de câblage (30) qui peut être reliée par une prise de contact de troisième type (32) à la ou aux cartes de technologie (12) et
- au moins un module de technologie qui comporte respectivement une ou plusieurs cartes de technologie (12), dont au moins une peut être reliée par une prise de deuxième type complémentaire au contact de branchement de deuxième type (28) à la carte de bus (24) et par une prise de troisième type complémentaire au contact de branchement de troisième type (32) à la carte de câblage (30) et qui comprend ou comprennent un volume de base de connexions d'entrée/de sortie avec la machine à contrôler et établit une connexion entre la carte de bus (24) et la carte de câblage (30).

2. Dispositif de commande selon la revendication 1,
dans lequel il est prévu un module d'unité centrale (20).

3. Dispositif de commande selon la revendication 1 ou 2,
dans lequel il est prévu comme module de commande un branchement bus à une unité centrale externe.

4. Dispositif de commande selon une des revendications 1 à 3,
dans lequel la carte de câblage (30) comporte substantiellement un circuit de sécurité, un câblage avec la machine à contrôler ainsi qu'un distributeur de tension.

5. Dispositif de commande selon la revendication 4,
dans lequel la carte de câblage (30) comporte une mémoire non volatile avec une logique de sécurité et un contrôleur qui actionne le circuit de sécurité.

6. Dispositif de commande selon la revendication 4,
dans lequel le module de technologie comporte une mémoire non volatile avec une logique de sécurité et un contrôleur qui actionne le circuit de sécurité disposé sur une carte de câblage (30).

7. Dispositif de commande selon une des revendications 1 à 6,
dans lequel le module de technologie comporte une unité centrale pour exécuter les tâches de la commande par programme enregistré (CPE).

8. Dispositif de commande selon une des revendications 1 à 7,
dans lequel le module de technologie comprend un module d'extension qui inclut des agrégats supplémentaire de saisie ou d'édition, des pilotes de sortie et/ou des circuits de protection d'entrée.

9. Dispositif de commande selon une des revendications 1 à 8,
dans lequel la carte de câblage (30) et la carte de bus (24) sont réalisées en bloc sur des zones séparées d'une seule carte.

10. Dispositif de commande selon une des revendications 1 à 9,
dans lequel il est prévu un support de module (2) sur lequel on peut fixer le module de technologie, la carte de câblage (30) et la platine de bus (24).

11. Dispositif de commande selon la revendication 10,
dans lequel la carte ou les cartes (12) du module de technologie est ou sont disposées sur le support de module (2) perpendiculairement à la carte de câblage (30) et à la carte de bus (24).

12. Dispositif de commande selon une des revendications 10 ou 1-1,
dans lequel la carte de câblage (30) et la carte de bus (24) sont fixées sur un côté arrière du support de module (2) et le module de technologie est fixé sur un côté avant du support de module (2).

13. Dispositif de commande selon une des revendications 10 à 12,
dans lequel le support de module (2) comporte des évidements (4) à travers lesquels on peut guider les contacts de branchement entre les différents modules (16) ou les différentes cartes (12, 24, 30) ainsi que des composantes individuelles disposées sur la carte de câblage (30).

14. Dispositif de commande selon une des revendications 10 à 13,
dans lequel le support de module (2) présente en outre des évidements d'assemblage par enclenchement (8) dans lesquels s'enclenchent les modules de commande (14).

15. Dispositif de commande selon une des revendications 10 à 14,
dans lequel il est prévu sur le support de module (2) des socles (22) pour un ou plusieurs modules d'extension du module de technologie.

16. Dispositif de commande selon une des revendications 1 à 15,
dans lequel les connexions d'entrée/de sortie du module de technologie ou de ses modules d'extension sont établies par des prises frontales préfabriquées.

17. Dispositif de commande selon une des revendications 1 à 16,
dans lequel les contacts de branchement de premier type (26) sont préfabriqués et réalisés de manière à établir une connexion de branchement aussi bien pour les agrégats numériques qu'analogiques.

18. Dispositif de commande selon une des revendications 10 à 17,
dans lequel les cartes (12) du module de technologie sont couplées par une ligne de jonction.

19. Dispositif de commande selon une des revendications 10 à 18,
dans lequel le support de module (2) est en tôle.
